# EUROPEAN PATENT APPLICATION

(11) **EP 4 765 205 A1**
(43) Date of publication of application: **24.06.2026**
(21) Application number: 25769344.0
(22) Date of filing: 07.03.2025
(51) Int. Cl.: H01L 23/64, H01G 4/005, H10N 97/00

(54) **SILICON CAPACITOR ELECTRODE STRUCTURE AND SILICON CAPACITOR**

(30) Priority: 12.03.2024 CN 202410277887; 05.03.2025 CN 202520378419 U; 05.03.2025 CN 202520378153 U
(71) Applicant: Suzhou Suna Opto-Electronics Co., Ltd, Suzhou, Jiangsu 215000 (CN)
(72) Inventor: JIN, Shan, Suzhou, Jiangsu 215000 (CN); HUANG, Zhiyuan, Suzhou, Jiangsu 215000 (CN); FEI, Xiaobin, Suzhou, Jiangsu 215000 (CN); HE, Tingting, Suzhou, Jiangsu 215000 (CN); LU, Jianya, Suzhou, Jiangsu 215000 (CN); HUANG, Yuyang, Suzhou, Jiangsu 215000 (CN)
(74) Representative: Santarelli
(86) International application number: PCT/CN2025/081330
(87) International publication number: WO 2025/190173

(57) **Abstract**

The present invention discloses a silicon capacitor electrode structure and a silicon capacitor. In the silicon capacitor electrode structure, multiple groups of columnar unit arrays are fabricated on the substrate according to different periodic grid distributions, and the multiple groups of columnar unit arrays are nested and combined to increase the surface area of the electrode structure while improving structural stability and reducing the equivalent series resistance to meet industrial requirements.

## Description

The present invention claims the priority of China patent application No. 202410277887.2, filed with Chinese Patent Office on March 12, 2024, and entitled " Silicon Capacitor Electrode Structure and Silicon Capacitor ", the priority of China patent application No. 202520378419.4, filed in Chinese Patent Office on March 5, 2025, and entitled " Silicon Capacitor Electrode Structure and Silicon Capacitor ", and the priority of China patent application No. 202520378153.3, filed in Chinese Patent Office on March 5, 2025, and entitled " Silicon capacitor electrode structure and silicon capacitor", the entire contents of these three applications are herein incorporated by reference.

### Technical Field

The present invention relates to micro-nano technology, in particular to a silicon capacitor electrode structure and a silicon capacitor.

### Background of the Invention

In the field of micro-nano technology, the demand for large capacitance leads to rising costs per square inch of semiconductor substrate area and growing requirements for capacitance. To increase capacitance density, the aspect ratio of the columns, which is defined as the ratio of its length to the smallest cross-sectional dimension perpendicular to its length direction, can be increased. The strategy to increase capacitance density is to increase the length of the columns, or reduce the cross-sectional size or footprint of the columns, so that more columns can be placed on the same substrate area. However, cylindrical columns with high aspect ratios are prone to fracture and/or tilting when subjected to shear forces, such as those that may occur during handling and/or processing. Traditional electrodes typically fail to meet the requirements for electrode surface area and structural stability in specific applications, thereby limiting the employment scope of capacitors. Secondly, there exists some unreasonable arrangements of the electrodes on the substrate, resulting in high equivalent series resistance (ESR) in the electrode structures.

The information disclosed in the background art section is intended solely to provide a general background understanding of the present invention and should not be construed as acknowledging or implying in any way that such information constitutes prior art known to those skilled in the art.

### Summary of the Invention

The objective of the present invention is to provide a silicon capacitor electrode structure and a silicon capacitor. In the silicon capacitor electrode structure, multiple groups of columnar unit arrays are fabricated on the substrate according to different periodic grid distributions, and the multiple groups of columnar unit arrays are nested and combined to increase the surface area of the electrode structure while improving structural stability and reducing the equivalent series resistance to meet industrial requirements.

To achieve the above objectives, the embodiment of the present invention provides a silicon capacitor electrode structure comprising a substrate, a first columnar unit array, and a second columnar unit array. The substrate has a first surface. The first columnar unit array is formed on the first surface of the substrate and comprises a plurality of first columnar units distributed in a first periodic grid. Each first columnar unit includes a first main portion A and a first main portion B located at both ends thereof, and a first connecting portion connecting the first main portion A and the first main portion B. A center point of the first main portion A of each first columnar unit constitutes a grid point of the first periodic grid. The second columnar unit array is formed on the first surface of the substrate and comprises a plurality of second columnar units distributed in a second periodic grid. Each second columnar unit includes a second main portion A and a second main portion B located at both ends thereof, and a second connecting portion connecting the second main portion A and the second main portion B. A center point of the second main portion A in each second columnar unit constitutes a grid point of the second periodic grid. Any grid point of the first periodic grid does not coincide with any grid point of the second periodic grid, and the first columnar unit is not in contact with the second columnar unit.

In one or more embodiments of the present invention, a straight-line connecting the center point of the first main portion A and the center point of the first main portion B of the first columnar unit on the first surface is parallel to or intersects with a straight-line connecting the center point of the second main portion A and the center point of the second main portion B of the second columnar unit.

In one or more embodiments of the present invention, a size of the second columnar unit is the same as that of the first columnar unit, and the second columnar unit is formed by moving the first columnar unit and rotating it by an angle α₁ about the center point of the first main portion A thereof.

In one or more embodiments of the present invention, a range of the α₁ angle is 0°-180°.

In one or more embodiments of the present invention, the α₁ angle is 90°.

In one or more embodiments of the present invention, the first periodic grid comprises a parallelogram grid having multiple cells ABCD; the second periodic grid comprises a parallelogram grid having multiple cells A'B'C'D'; wherein the parallelogram grid with cells ABCD has same size as that of the parallelogram grid with cells A'B'C'D'.

In one or more embodiments of the present invention, a side AB is parallel to a side A'B', and a side AC is parallel to a side A'C'.

In one or more embodiments of the present invention, the center point of each second main portion A in each second columnar unit is located at a center point of a cell of the first periodic grid which is formed by using the center point of the first main portion A in the first columnar unit as a grid point.

In one or more embodiments of the present invention, the first columnar unit comprises a columnar portion protruding from the first surface and/or a hole recessed into the first surface.

In one or more embodiments of the present invention, the second columnar unit comprises a columnar portion protruding from the first surface and/or a hole recessed into the first surface.

In one or more embodiments of the present invention, the first main portion A is configured as a cylinder or circular hole with a diameter of R_{A1}, the first main portion B is configured as a cylinder or circular hole with a diameter of RB1, and the first connecting portion has a length R₁ perpendicular to a line connecting the center point of the first main portion A and the center point of the first main portion B, and R_{A1} = R_{B1} = R₁. The second main portion A is configured as a cylinder or circular hole with a diameter of R_{A2}, the second main portion B is configured as a cylinder or circular hole with a diameter of R_{B2}, and the second connecting portion has a length R₂ perpendicular to a line connecting the center point of the second main portion A and the center point of the second main portion B, and R_{A2} = R_{B2} = R₂.

In one or more embodiments of the present invention, the first periodic grid comprises a quadrilateral grid having multiple cells ABCD; the second periodic grid comprises a quadrilateral grid having multiple cells A'B'C'D'.

The quadrilateral grid with cells ABCD has the same size as that of the quadrilateral grid with cells A'B'C'D', a grid points of the quadrilateral grid with cells A'B'C'D' are located within the cells of the quadrilateral grid with cells ABCD, and a grid points of the quadrilateral grid with cells A'B'C'D' are located on diagonals of the cells of the quadrilateral grid with cells ABCD.

In one or more embodiments of the present invention, the grid points of the quadrilateral grid with cells A'B'C'D' are located on an n-equidistant lines of the diagonals of the cells of the quadrilateral grid with cells ABCD, and n is a constant.

In one or more embodiments of the present invention, the first periodic grid includes a triangular grid having multiple cells ABC; the second periodic grid includes a triangular grid having multiple cells A'B'C'.

The triangular grid with cells ABC is the same size as the triangular grid with cells A'B'C', and a grid points of the triangular grid with cells A'B'C' are located on grid lines of the triangular grid with cells ABC.

In one or more embodiments of the present invention, grid points of the triangular grid with cells A'B'C' are located at an n-equidistant lines of the grid lines of the cells of the triangular grid with cells ABC, and n is a constant.

In one or more embodiments of the present invention, the line connecting the center point of the first main portion A and the center point of the first main portion B in the first columnar unit has a length L₁, and the length L₁ is greater than or equal to a half circumference of the first main portion A or the first main portion B. The line connecting the center point of the second main portion A and the center point of the second main portion B in the second columnar unit has a length L₂, and the length L₂ is greater than or equal to a half circumference of the second main portion A or the second main portion B.

In one or more embodiments of the present invention, the silicon capacitor electrode structure further comprises a third columnar unit array, which is formed on the first surface of the substrate and comprises a plurality of third columnar units arranged in a third periodic grid pattern. Each third columnar unit includes a third main portion A and a third main portion B located at both ends thereof, and a third connecting portion connecting the third main portion A and the third main portion B. A center point of the third main portion A in the third columnar unit constitutes a grid point of the third periodic grid. Any grid point of the third periodic grid does not overlap with any grid point of the second periodic grid or the first periodic grid, and the third columnar unit does not come into contact with the first columnar unit or the second columnar unit.

In one or more embodiments of the present invention, a straight-line passing through center points of the third main portion A and the third main portion B of the third columnar unit is parallel to or intersects a straight-line passing through the center of the first main portion A and the first main portion B of the first columnar unit or a straight-line passing through the center points of the second main portion A and the second main portion B of the second columnar unit.

In one or more embodiments of the present invention, a size of the third columnar unit is the same as that of the first columnar unit, and the third columnar unit is formed by moving the first columnar unit and rotating it by an angle α₂ about the center point of the first main portion A thereof, and a range of the α₂ angle is 0°-180°.

In one or more embodiments of the present invention, the first periodic grid comprises a parallelogram grid having cells ABCD; the second periodic grid comprises a parallelogram grid having cells A'B'C'D'; the third periodic grid comprises a parallelogram grid having cells A"B"C"D"; the size of the parallelogram grid with cells ABCD, the parallelogram grid with cells A'B'C'D', and the parallelogram grid with cells A"B"C"D" are all the same.

In one or more embodiments of the present invention, the first periodic grid comprises an isosceles triangular grid having cells ABC; the second periodic grid comprises an isosceles triangular grid having cells A'B'C'; the third periodic grid comprises an isosceles triangular grid having cells A"B"C"; the isosceles triangular grid with cells ABC, the isosceles triangular grid with cells A'B'C', and the isosceles triangular grid with cells A"B"C" all have the same size.

In one or more embodiments of the present invention, the third columnar unit comprises a columnar portion protruding from the first surface and/or a hole recessed into the first surface.

In one or more embodiments of the present invention, the first periodic grid includes a quadrilateral grid having cells ABCD; the second periodic grid includes a quadrilateral grid having cells A'B'C'D'; the third periodic grid includes a quadrilateral grid having cells A"B"C"D". The quadrilateral grid with cells A"B"C"D" has the same size as the quadrilateral grid with cells ABCD and the quadrilateral grid with cells A'B'C'D'.

The grid points of the quadrilateral grid with cells A"B"C"D" are located within the cells of the quadrilateral grid with cells ABCD, and the grid points of the quadrilateral grid with cells A"B"C"D" are located on the diagonals of the cells of the quadrilateral grid with cells ABCD.

The grid points of the quadrilateral grid with cells A"B"C"D" are located within the cells of the quadrilateral grid with cells A'B'C'D', and the grid points of the quadrilateral grid with cells A"B"C"D" are located on the diagonals of the cells of the quadrilateral grid with cells A'B'C'D'.

In one or more embodiments of the present invention, the grid points of the quadrilateral grid with cells A"B"C"D" are located on the n-equidistant lines of the diagonals of the cells of the quadrilateral grid with cells ABCD, and n is a constant.

The grid points of the quadrilateral grid with cells A"B"C"D" are located on the n-equidistant lines of the diagonals of the cells of the quadrilateral grid, and n is a constant with cells A'B'C'D'.

In one or more embodiments of the present invention, the first periodic grid comprises a triangular grid having cells ABC; the second periodic grid comprises a triangular grid having cells A'B'C'; the third periodic grid comprises a triangular grid having cells A"B"C".

The triangular grid with cells A"B"C' has the same size as the triangular grid with cells ABC and the triangular grid with cells A'B'C'.

The grid points of the triangular grid with cells A"B"C' are located on the grid lines of the triangular grid with cells ABC.

The grid points of the triangular grid with cells A"B"C' are located on the grid lines of the triangular grid with cells A'B'C'.

In one or more embodiments of the present invention, the grid points of the triangular grid with cells A"B"C" are located at the n-equidistant lines of the grid lines of the cells of the triangular grid with cells ABC, and n is a constant.

The grid points of the triangular grid with cells A"B"C" are located at the n-equidistant lines of the grid lines of the cells of the triangular grid with cells A'B'C', and n is a constant.

In one or more embodiments of the present invention, the third main portion A is configured as a cylinder or circular hole with a diameter of R_{A3}, the third main portion B is configured as a cylinder or circular hole with a diameter of R_{B3}, and the first connecting portion has a length R₃ perpendicular to the center line connecting the third main portion A and the third main portion B, and R_{A3} = R_{B3} = R₃. The line connecting the center point of the third main portion A and the center point of the third main portion B in the third columnar unit has a length L₃, and the length L₃ is greater than or equal to a half circumference of the third main portion A or the third main portion B.

In one or more embodiments of the present invention, a side AB is parallel to a side A'B', and a side AC is parallel to a side A'C'.

The present invention also provides a silicon capacitor comprising an above-mentioned silicon capacitor electrode structure.

Compared with the prior art, the silicon capacitor electrode structure according to the embodiment of the present invention can increase the surface area of the electrode in a limited space and improve the capacitance of the capacitor so that it can store more charge by using a nested combination of multiple sets of columnar units distributed in different periodic grids.

According to the silicon capacitor electrode structure of the invention, the special shapes of the first, second, and third columnar units reduce the accumulation of electrons on the outer peripheral surface, and in combination with the arrangement of different periodic grids, further reduce the equivalent series resistance (ESR) of the silicon capacitor electrode structure.

According to the silicon capacitor electrode structure of the present invention, the surface area is increased by arranging periodic grids in different arrays. This allows the volume of the capacitor to be reduced while maintaining the capacitance unchanged, which is very important for integration into small electronic devices, enabling higher capacitance to be achieved in a limited space.

The silicon capacitor electrode structure according to the present invention can improve the energy density. Since the energy density of a capacitor is related to its capacitance and operating voltage, more energy can be stored in the same volume by increasing the capacitance. The silicon capacitor electrode structure of the present invention increases the surface area of the electrodes in the same space by combining and nesting different arrays, thereby improving the capacitance of the capacitor.

The silicon capacitor electrode structure according to the embodiment of the present invention can further improve performance and stability. The columnar unit array arranged in a periodic grid can provide a uniform electric field distribution, which helps to improve the performance and stability of the capacitor. The uniform electric field distribution helps to reduce the leakage current of the capacitor, improve the insulation performance, and reduce losses. The columnar unit array arranged in a periodic grid can be achieved through a precise manufacturing process, improving the consistency of the manufacturing process. This helps to reduce performance variations among capacitors and enhance manufacturing controllability.

The silicon capacitor electrode structure according to the invention improves mechanical stability and enhances heat dissipation performance. The periodic grid arrangement of the columnar units provides better mechanical stability. This is particularly important for capacitors used in environments subject to vibration or mechanical stress. The periodic grid arrangement of the columnar units also improves the heat dissipation performance of the capacitor, as the gaps between the units facilitate air flow and reduce the operating temperature of the capacitor.

According to the silicon capacitor electrode structure of the invention, through the random path identical dielectric (resistance) model, multiple groups of columnar unit arrays are nested and arranged, making it easier to obtain information regarding the distribution of conductive paths and charge transfer behavior in the silicon capacitor electrode structure.

According to the silicon capacitor electrode structure of the invention, through a random conductive path penetration model, the nested arrangement of multiple sets of columnar unit arrays is simulated and analyzed for the random parallel connection of the equivalent resistances of the three-dimensional (3D) capacitor structure, which allows for better design of the 3D morphology and prediction of the capacitor ESR.

### Brief Description of the Drawings

FIG. 1 is a schematic diagram of the planar morphology of the silicon capacitor electrode structure according to a first embodiment of the present invention.
FIG. 2 is an enlarged view showing part of FIG. 1.
FIG. 3 is a schematic diagram of the planar morphology of the silicon capacitor electrode structure according to a second embodiment of the present invention.
FIG. 4 is an enlarged view showing part of FIG. 3.
FIG. 5 is a capacitance density simulation diagram of the silicon capacitor electrode structure according to the second embodiment of the present invention and the electrode structure of the traditional trident column model.
FIG. 6 is a simulation diagram of the equivalent series resistance (ESR) of the silicon capacitor electrode structure according to the second embodiment of the present invention and the electrode structure of the traditional trident column model.
FIG. 7 is a schematic diagram of the planar morphology of the silicon capacitor electrode structure according to a third embodiment of the present invention.
FIG. 8 is an enlarged view showing part of FIG. 7.
FIG. 9 is a schematic diagram of the planar morphology of the silicon capacitor electrode structure according to a fourth embodiment of the present invention.
FIG. 10 is an enlarged view showing part of FIG. 9.
FIG. 11 is an enlarged view showing another part of FIG. 9.
FIG. 12 is a schematic diagram of the planar morphology of the silicon capacitor electrode structure according to a fifth embodiment of the present invention.
FIG. 13 is an enlarged view showing part of FIG. 12.
FIG. 14 is a capacitance density simulation diagram of the silicon capacitor electrode structure according to the fifth embodiment of the present invention and the electrode structure of the traditional trident column model.
FIG. 15 is a simulation diagram of the equivalent series resistance (ESR) of the silicon capacitor electrode structure according to the fifth embodiment of the present invention and the electrode structure of the traditional trident column model.
FIG. 16 is a schematic diagram of the planar morphology of the silicon capacitor electrode structure according to a sixth embodiment of the present invention.
FIG. 17 is an enlarged view showing part of FIG. 16.
FIG. 18 is a capacitance density simulation diagram of the silicon capacitor electrode structure according to the sixth embodiment of the present invention and the electrode structure of the traditional trident column model.
FIG. 19 is a simulation diagram of the equivalent series resistance (ESR) of the silicon capacitor electrode structure according to the sixth embodiment of the present invention and the electrode structure of the traditional trident column model.
FIG. 20 is a diagram of the electrode structure of the traditional trident column model.
FIG. 21 is a capacitance density simulation diagram of the silicon capacitor electrode structure according to the second, fifth, and sixth embodiments of the present invention and the electrode structure of the traditional trident column model.
FIG. 22 is a normalized ESR simulation diagram of the silicon capacitor electrode structure according to the second, fifth, and sixth embodiments of the present invention and the electrode structure of the traditional trident column model.

### Detailed Description of Embodiments

The following description of the specific embodiments of the present invention is provided with reference to the accompanying drawings. However, it should be understood that the scope of protection of the present invention is not limited to the specific embodiments described herein.

Unless otherwise explicitly stated, the terms "include," "comprise," "including," and variations thereof are to be construed as non-exclusive, such that they encompass the listed elements or components but do not exclude additional elements or components.

As disclosed in the section of background art, in order to increase the capacitance density, the ratio of the length to the width of the column can be increased, i.e., the length of the column can be increased or the cross-sectional size or footprint of the column can be reduced, so that more columns can be placed on the same substrate area. However, cylindrical columns with high aspect ratios are prone to fracture and/or tilting when subjected to shear forces, such as those that may occur during handling and/or processing. Traditional electrodes typically fail to meet the requirements for electrode surface area and structural stability in specific applications, thereby limiting the employment scope of capacitors. Secondly, there exists some unreasonable arrangements of the electrodes on the substrate, resulting in high equivalent series resistance (ESR) in the electrode structures.

To address the aforementioned problems, the present invention provides a silicon capacitor electrode structure based on a Random Path Identical Dielectric (Resistance) Model and a Random Conductive Path Percolation Model. First, the stability of the electrode structure is enhanced by constructing a columnar unit with a main portion and a connecting portion. Secondly, the columnar units are arranged in arrays according to different periodic grids, and multiple groups of columnar unit arrays arranged in different periodic grids are nested and combined. The columnar units in multiple groups of columnar unit arrays have different angles relative to the substrate, which enhances the stress-bearing capacity of the columnar units while further increasing a surface area of the electrodes in a limited space and reducing the equivalent series resistance to meet industrial requirements.

The Random Path Identical Dielectric (Resistance) Model is used to describe the distribution and properties of randomly distributed conductive paths in dielectric materials. This model is applied to analyze the electrical conductivity behavior in complex dielectric, where charges are transported through randomly distributed conductive paths within the material. By simulating and analyzing the Random Path Identical Dielectric Model, information about the distribution of conductive paths and charge transport behavior within the material can be obtained. This model is a theoretical simplification, and the actual electrical behavior of materials may be influenced by additional factors such as material microstructure and the properties of charge carriers. When the Random Path Identical Dielectric (Resistance) Model used, appropriate modifications and verification should be performed based on the specific material and experimental conditions to ensure the accuracy and applicability of the model.

The Random Conductive Path Percolation Model is employed to describe the distribution and properties of randomly distributed conductive paths in complex dielectric materials. This model is applied to analyze the percolation behavior of conductivity in materials. The Random Conductive Path Percolation Model is utilized to characterize the random parallel properties of 3D capacitive equivalent resistance, taking into account the random distribution of conductive paths. The equivalent resistances may be connected in parallel in a periodic and regular distribution. By simulating and analyzing such random parallel configurations, the Random Conductive Path Percolation Model may facilitate improved prediction of equivalent series resistance (ESR).

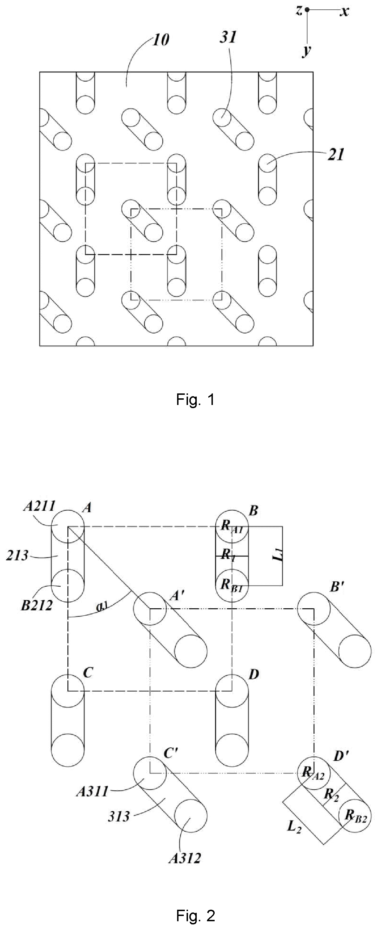

As shown in FIGS. 1, 3, 5, and 7, the silicon capacitor electrode structure of the present invention comprises: a substrate 10, a first columnar unit array, and a second columnar unit array.

The substrate 10 has a first surface that serves as the bottom support for the first columnar unit array, the second columnar unit array, and subsequent other columnar unit arrays. A three-dimensional Cartesian coordinate system is established with the first surface of substrate 10 as the bottom plane. A lateral direction is defined as an x-direction, a longitudinal direction is defined as a y-direction, and a direction perpendicular to the first surface is defined as a z-direction.

The first columnar unit array is formed on the first surface of the substrate 10. The first columnar unit array includes a plurality of first columnar units 21.

As shown in FIG. 2, the first columnar unit 21 extends in the z-direction from the first surface and has an extended length LZ1. The first columnar unit 21 forms a part of the electrode structure. Each first columnar unit 21 includes a first main portion A211 and a first main portion B212 located at both ends thereof in a direction parallel to the first surface, and a first connecting portion 213 connecting the first main portion A211 and the first main portion B212. In the z-direction, the first main portion A211 and the first main portion B212 have same lengths, both being L_{Z1}. In the z-direction, the lengths of the first connecting portion 213, the first main portion A211 and the first main portion B212 are the same, and both are L_{Z1}.

It is understood that the z-direction includes a protruding direction of the first surface and a recessed direction of the first surface, so that the first columnar unit 21 can be a column protruding from the first surface and/or a hole recessed into the first surface.

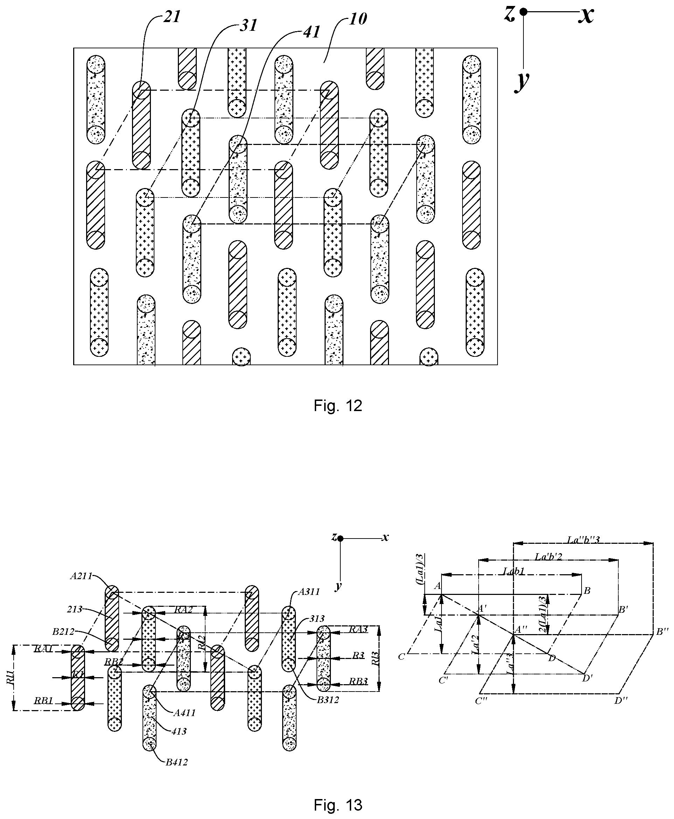

Preferably, the first main portion A211 is constructed as a circular columnar structure or circular hole structure with a diameter of R_{A1}. The first main portion B212 is constructed as a circular columnar structure or circular hole structure with a diameter of R_{B1}. A line connecting the center point of the first main portion A211 and the center point of the first main portion B212 in the first columnar unit 21 has a length L₁, which is greater than or equal to a half of the circumference of the first main portion A211 or the first main portion B212. This configuration allows the first columnar unit 21 to have a larger surface area. The first columnar unit 21 has a length R_{I1} in the direction of the line connecting the center point of the first main portion A211 and the center point of the first main portion B212 (in the y-direction in FIG. 13), and the first connecting portion 213 has a length R₁ perpendicular to the line connecting the center point of the first main portion A211 and the center point of the first main portion B212, where R_{A1} = R_{B1} = R₁, R_{I1} = nR_{A1} = nR_{B1}, and n is a constant.

Therefore, the first main portion A211 has a first cross section perpendicular to the first surface (i.e., in the z-direction) and passing through the center point of the first main portion A211 itself. The first main portion B212 has a second cross section perpendicular to the first surface (i.e., in the z-direction) and passing through the center point of the first main portion B212 itself. The first connecting portion 213 has a third cross section perpendicular to the line connecting the center point of the first main portion A211 and the center point of the first main portion B212 and perpendicular to the first surface. Any third cross section in the direction from the first main portion A211 to the first main portion B212 of the first connecting portion 213 always completely coincides with the first cross section of the first main portion A211 and the second cross section of the first main portion B212.

A plurality of first columnar units 21 are distributed in a first periodic grid pattern on the first surface of the substrate 10. The center points of the first main portions A211 of the first columnar units 21 constitute the grid points of the first periodic grid.

It can be understood that, in one embodiment, the center points of the first main portions A211 of the four adjacent first columnar units 21 in two adjacent rows and two adjacent columns constitute the four vertices A, B, C, and D of a cell ABCD. Accordingly, the first periodic grid may comprise a quadrilateral grid composed of multiple cells ABCD. Preferably, the first periodic grid includes a parallelogram grid with multiple cells ABCD, i.e., the cells ABCD are parallelogram cells.

In one embodiment, the center points of the first main portions A211 of the three adjacent first columnar units 21 in two adjacent rows constitute the three vertices A, B, and C of a cell ABC. The first periodic grid may then include a triangular grid having multiple cells ABC. Preferably, the first periodic grid includes triangular grid with multiple cells ABC, i.e., cells ABC are isosceles or equilateral triangular cells.

The second columnar unit array is formed on the first surface of the substrate 10. The second columnar unit array includes a plurality of second columnar units 31.

The second columnar unit 31 extends in the z-direction from the first surface and has an extended length L_{Z2}. The second columnar unit 31 forms a part of the electrode structure. Each second columnar unit 31 includes a second main portion A311 and a second main portion B312 located at both ends thereof in a direction parallel to the first surface, and a second connecting portion 313 connecting the second main portion A311 and the second main portion B312. In the z-direction, the second main portion A311 and the second main portion B312 have same lengths, both being L_{Z2}. In the z-direction, the length of the second connecting portion 313 is the same as the lengths of the second main portion A311 and the second main portion B312, both being L_{Z2}.

It is understood that the z direction includes a protruding direction of the first surface and a recessed direction of the first surface, so that the second columnar unit 31 can be a column protruding from the first surface and/or a hole recessed into the first surface.

Preferably, the second main portion A311 is constructed as a circular columnar structure or circular hole structure with a diameter of R_{A2}. The second main portion B312 is constructed as a circular columnar structure or circular hole structure with a diameter of R_{B2}. The line connecting the center point of the second main portion A311 and the center point of the second main portion B312 in the second columnar unit 31 has a length L₂, which is greater than or equal to a half of the circumference of the second main portion A311 or the second main portion B312. This configuration allows the second columnar unit 31 to have a larger surface area. The second columnar unit 31 has a length R_{I2} in the direction of the line connecting the center point of the second main portion A311 and the center point of the second main portion B312 (in the y-direction in FIG. 12), and the second connecting portion 313 has a length R₂ perpendicular to the line connecting the center point of the second main portion A311 and the center point of the second t main portion B312, where R_{A2} = R_{B2} = R₂, R_{I2} = nR_{A2} = nR_{B2}, and n is a constant.

Therefore, the second main portion A311 has a fourth cross section perpendicular to the first surface (i.e., in the z-direction) and passing through the center point of the second main portion A311 itself. The second main portion B312 has a fifth cross section perpendicular to the first surface (i.e., in the z-direction) and passing through the center point of the second main portion B312 itself. The second connecting portion 313 has a sixth cross section perpendicular to the line connecting the center point of the second main portion A311 and the center point of the second main portion B312 and perpendicular to the first surface. Any sixth cross section in the direction from the second main portion A311 to the second main portion B312 of the second connecting portion 313 always completely coincides with the fourth cross section of the second main portion A311 and the fifth cross section of the first main portion B312.

A plurality of second columnar units 31 are distributed in a second periodic grid pattern on the first surface of the substrate 10. The center points of the second main portions A311 of the second columnar units 31 constitute the grid points of the second periodic grid.

It can be understood that, in one embodiment, the center points of the second main portions A311 of the four adjacent second columnar units 31 in two adjacent rows and two adjacent columns constitute the four vertices A', B', C', and D' of the cell A'B'C'D'. Then, the second periodic grid can include a quadrilateral grid having multiple cells A'B'C'D'. Preferably, the second periodic grid includes a parallelogram grid with cells A'B'C'D', i.e., cells A'B'C'D' are parallelogram cells.

In one embodiment, the center points of the second main portions A311 of the three adjacent second columnar units 31 in adjacent rows constitute the three vertices A', B', and C' of the cell A'B'C'. The second periodic grid may then comprise a triangular grid having multiple cells A'B'C'. Preferably, the second periodic grid includes triangular grid units with multiple cells A'B'C', i.e., cells A'B'C' are isosceles or equilateral triangular cells.

On the first surface of the substrate 10, the first periodic grid formed by the first columnar unit array is nested with the second periodic grid formed by the second columnar unit array.

In one embodiment, the parallelogram grid with multiple cells ABCD in the first periodic grid has the same size as the parallelogram grid with multiple cells A'B'C'D' in the second periodic grid, and a side AB of cell ABCD is parallel to a side A'B' of cell A'B'C'D', a side AC of the cell ABCD is parallel to a side A'C' of the cell A'B'C'D'. Any grid point of the first periodic grid, i.e., the first main portion A211 of the first columnar unit 21, does not coincide with any grid point of the second periodic grid, i.e., the second main portion A311 of the second columnar unit 31, and the first columnar unit 21 and the second columnar unit 31 are not in contact with each other.

In one embodiment, the isosceles or equilateral triangular grid cells with cells ABC in the first periodic grid are the same size as the isosceles or equilateral triangular grid cells with cells A'B'C' in the second periodic grid, and the side AB in cell ABC is parallel to the side A'B' in cell A'B'C'. Any grid point of the first periodic grid, i.e., the first main portion A211 of the first columnar unit 21, is not coincident with any grid point of the second periodic grid, i.e., the second main portion A311 of the second columnar unit 31, and the first columnar unit 21 and the second columnar unit 31 are not in contact with each other.

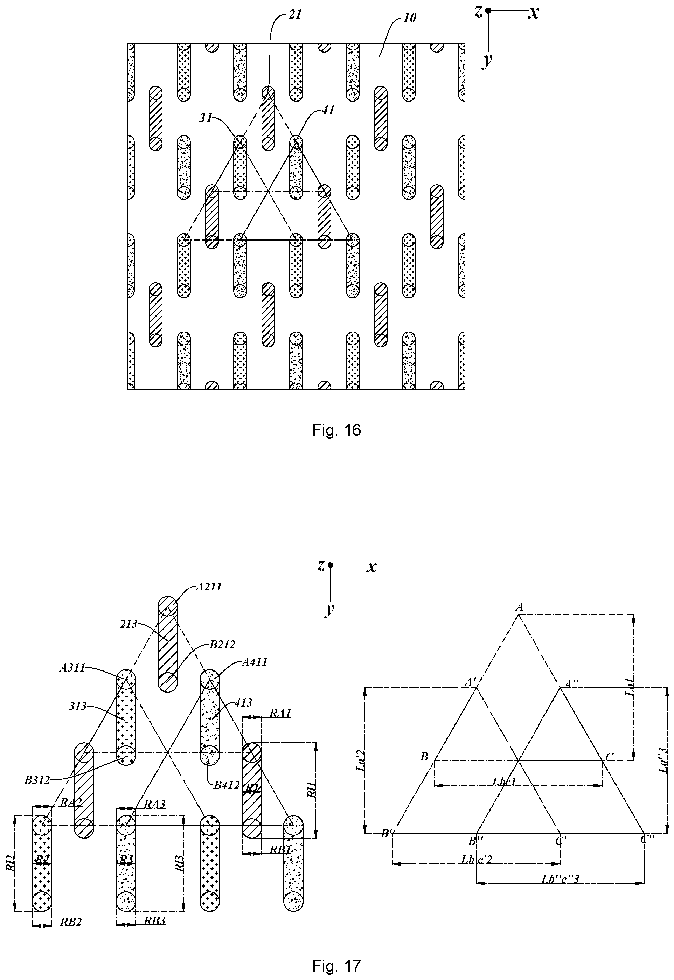

In one embodiment, as shown in FIG. 12 and FIG. 16, the straight-line connecting the center point of the first main portion A211 and the center point of the second main portion B212 of the first columnar unit 21 is parallel to the straight-line connecting the center point of the second main portion A311 and the center point of the second main portion B312 of the second columnar unit 31.

In another embodiment, as shown in FIG. 2, the straight-line connecting the center point of the first main portion A211 and the center point of the second main portion B212 in the first columnar unit 21 intersects the straight-line connecting the center point of the second main portion A311 and the center point of the second main portion B312 in the second columnar unit 31.

Preferably, the size of the second columnar unit 31 is exactly the same as that of the first columnar unit 21, and the second columnar unit 31 can be regarded as formed by translating the first columnar unit 21 as a whole. Alternatively, the second columnar unit 31 can be regarded as formed by moving the first columnar unit 21 and rotating it by an angle α₁ around the center point of its first main portion A211. The direction of rotation can be clockwise or counterclockwise. The angle α₁ can range from 0° to 180°, and the lateral distance between the center point of the second main portion A311 of the second columnar unit 31 and the center point of the first main portion A211 of the first columnar unit 21 is x₁, and the longitudinal distance is y₁.

Referring to FIGS. 1 and 2, in the silicon capacitor electrode structure of the first embodiment shown in FIGS. 1 and 2, the first periodic grid formed by the first columnar unit array is distributed in a square grid, and each side AB of each cell ABCD is parallel to the x-direction, and each side AC is parallel to the y-direction. The second periodic grid formed by the second columnar unit array is also distributed in a square grid, and the side A'B' of each cell A'B'C'D' is parallel to the x-direction, and the side A'C' is parallel to the y-direction. The length of side AB is equal to the length of side A'B', and the length of side AC is equal to the length of side A'C'. Preferably, the center point of each second main portion A311 of each second columnar unit 31 is located at the center point of a cell in the first periodic grid. It can be understood that the second columnar unit array is formed by firstly translating the first columnar unit array as a whole along the x-direction by 1/2 the length of side AB, then translating it along the y-direction by 1/2 the length of side AC, and finally rotating each first columnar unit 21 by an angle α₁ about the center point of the first main portion A211. In this embodiment, the angle α₁ is 45°.

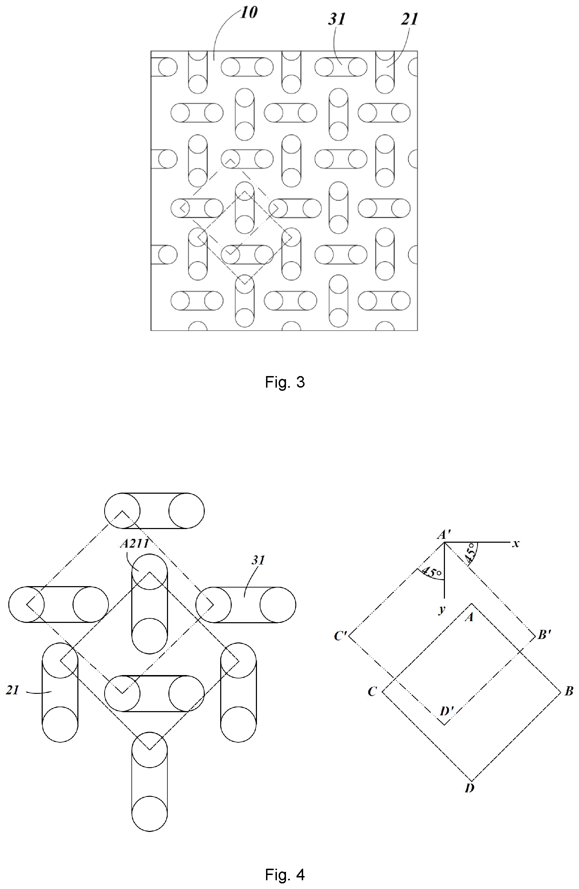

Referring to FIGS. 3 and 4, in the silicon capacitor electrode structure of the second embodiment shown in FIGS. 3 and 4, the first periodic grid formed by the first columnar unit array is distributed in a diamond-shaped grid, and each side AB of each cell ABCD forms an angle of 45° with the x-direction, and each side AC forms an angle of 45° with the y-direction. The second periodic grid formed by the second columnar unit array is also distributed in a diamond-shaped grid, and side A'B' of each cell A'B'C'D' forms an angle of 45° with the x-direction, and side A'C' forms an angle of 45° with the y-direction. The length of each side AB is equal to the length of each side A'B', and the length of the side AC is equal to the length of the side A'C'. It can be understood that the second columnar unit array is formed by firstly translating the first columnar unit array as a whole a certain distance x₁ in the x-direction, then translating it a certain distance y₁ in the y-direction, and finally rotating each first columnar unit 21 by an angle α₁ about the center point of the first main portion A211. In this embodiment, the angle α₁ is 90°.

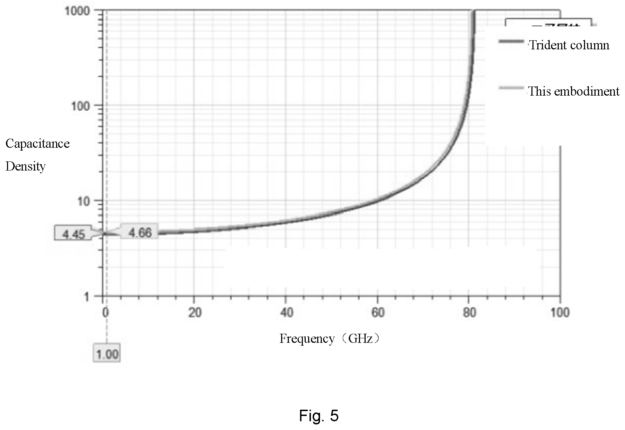

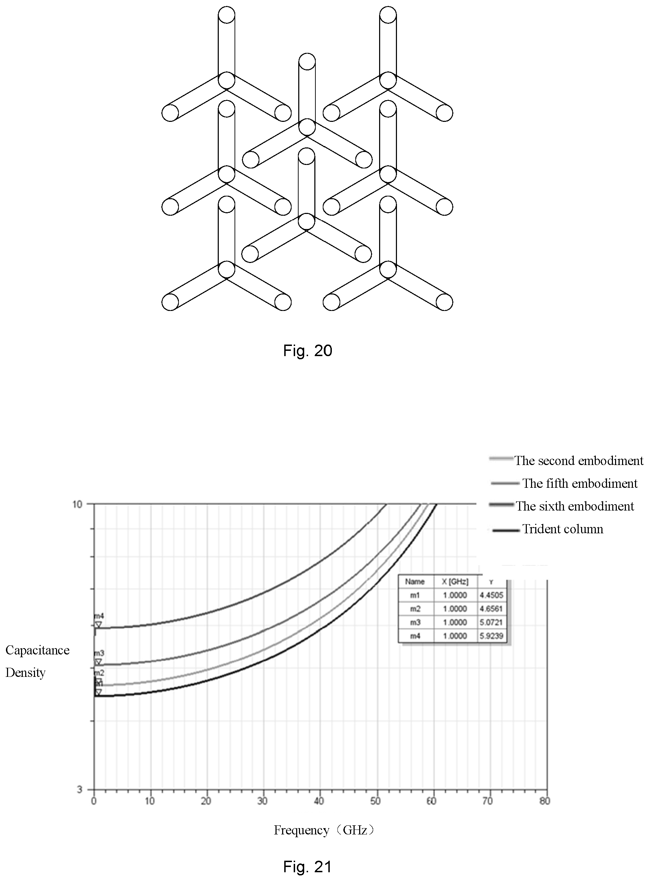

FIG. 5 is a capacitance density simulation diagram of the silicon capacitor electrode structure in the second embodiment of the present invention and the electrode structure of the traditional trident column model (as shown in FIG. 20). In the electrode structure of the trident column model shown in FIG. 20, the size of a single column in the trident column unit is same as the size of the column unit in the present embodiment. In this embodiment, three groups of identical columnar unit arrays are nested, and the sizes of the columnar units are all: R_{I1}=5R_{A1}=5R_{B1}. It can be seen from FIG. 5 that C_{in this embodiment} = 4.66nF/mm²@1GHz, and C _{trident} column = 4.45nF/mm²@1GHz.

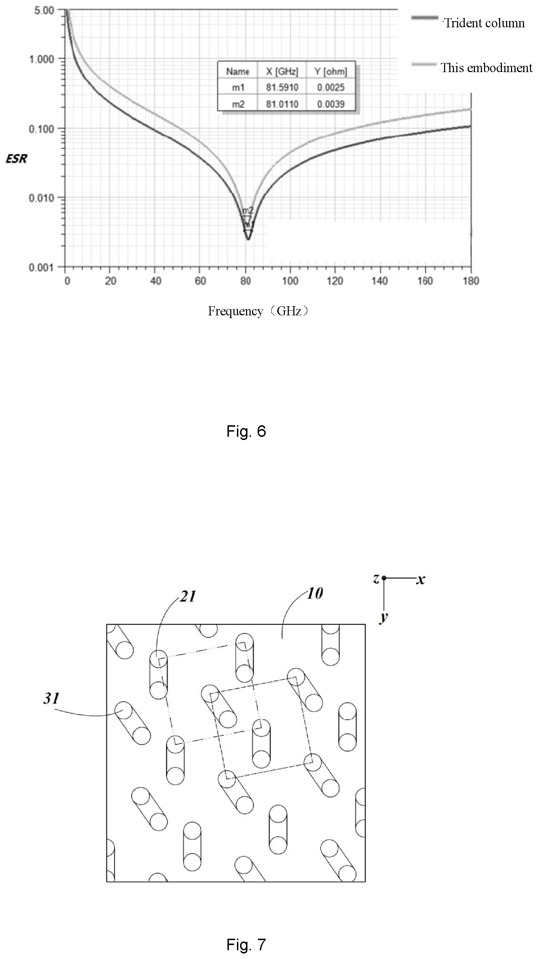

FIG. 6 is an ESR simulation diagram of the silicon capacitor electrode structure in the second embodiment of the present invention and the electrode structure of the traditional trident column model (as shown in FIG. 20). In the electrode structure of the trident column model shown in FIG. 20, the size of a single column in the base unit of the trident column is consistent with the size of the columnar unit in the present embodiment. In this embodiment, three groups of identical columnar unit arrays are nested, and the dimensions of the columnar units are all: R_{I1}=5R_{A1}=5R_{B1}. It can be seen from FIG. 6 that ESR _{in this embodiment} = 3.9mohm@SRF, and ESR _{trident column} = 2.5mohm@SRF.

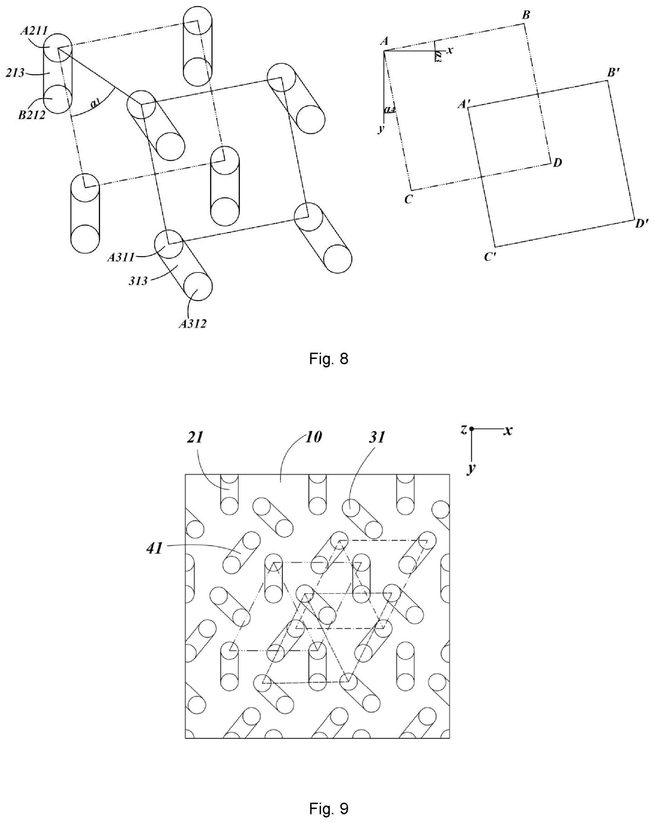

Referring to FIGS. 7 and 8, in the silicon capacitor electrode structure of the third embodiment shown in FIGS. 7 and 8, the first periodic grid formed by the first columnar unit array is also distributed in a square grid, and each side AB of each cell ABCD forms an angle of α₃ with the x-direction, and the side AC forms an angle of α₄ with the y-direction. Preferably, α₄ = α₃. The second periodic grid formed by the second columnar unit array is also distributed in a square grid, and each side A'B' of each cell A'B'C'D' forms an angle α₃ with the x-direction, and the side A'C' forms an angle α₄ with the y-direction. Preferably, α₄ = α₃. The length of side AB is equal to the length of side A'B', and the length of side AC is equal to the length of side A'C'. Preferably, the center point of each second main portion A311 of each second columnar unit 31 is located at the center point of a cell in the first periodic grid. It can be understood that the second columnar unit array is formed by firstly translating the first columnar unit array as a whole along the direction of side AB by 1/2 the length of side AB, then translating it along the direction of side AC by 1/2 the length of side AC, and finally rotating each first columnar unit 21 by an angle α₁ about the center point of the first main portion A211. The angle α₁ is 0°-180°.

In the above embodiment, the silicon capacitor electrode structure includes two groups of columnar unit arrays. The silicon capacitor electrode structure may also include three groups of columnar unit arrays. The first columnar unit in the first columnar unit array and the second columnar unit in the second columnar unit array are the same as those in the above embodiment and are not described in detail in this embodiment.

Referring to FIG. 9, a third columnar unit array is formed on the first surface of the substrate 10. The third columnar unit array includes a plurality of third columnar units 41.

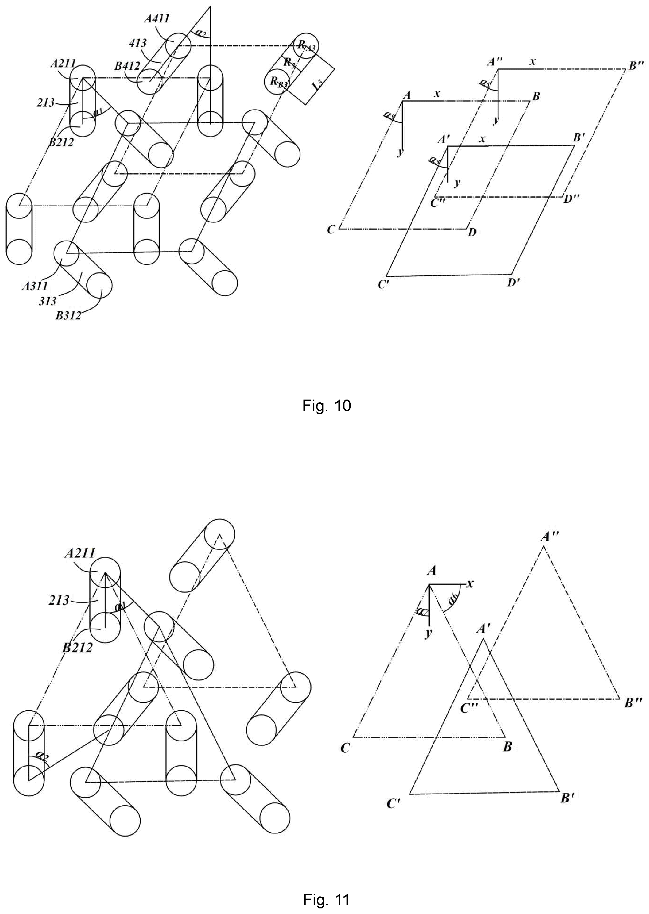

Referring to FIG. 10, the third columnar unit 41 extends from the first surface in the z-direction, and the length of the extension is L_{Z3}. The third columnar unit 41 is part of the electrode structure. Each third columnar unit 41 includes a third main portion A411 and a third main portion B412 located at both ends in a direction parallel to the first surface, and a third connecting portion 413 connecting the third main portion A411 and the third main portion B412. In the z-direction, the third main portion A411 and the third main portion B412 have same lengths, both being L_{Z3}. In the z-direction, the length of the third connecting portion 413 is the same as the lengths of the third main portion A411 and the third main portion B412, both being L_{Z3}.

It is understood that the z-direction includes a protruding direction of the first surface and a recessed direction of the first surface, so that the third columnar unit 41 may be a column protruding from the first surface and/or a hole recessed into the first surface.

Preferably, the third main portion A411 is constructed as a circular columnar structure or circular hole structure with a diameter of R_{A3}. The third main portion B412 is constructed as a circular columnar structure or circular hole structure with a diameter of R_{B3}. The line connecting the center point of the third main portion A411 and the center point of the third main portion B412 in the third columnar unit 41 has a length L₃, and the length L₃ is greater than or equal to a half of the circumference of the third main portion A411 or the third main portion B412, so that the third columnar unit 41 has a larger surface area. The third columnar unit 41 has a length R_{I3} in the direction of the line connecting the center point of the third main portion A411 and the center point of the third main portion B412 (in the y-direction in FIG. 13). The third connecting portion 413 has a length R₃ perpendicular to the line connecting the center point of the third main portion A411 and the center point of the third main portion B412, where R_{A3} = R_{B3} = R₃, R_{I3} = nR_{A3} = nR_{B3}, and n is a constant.

Therefore, the third main portion A411 has a seventh cross section perpendicular to the first surface (i.e., in the z-direction) and passing through the center point of the third main portion A411 itself. The third main portion B412 has an eighth cross section perpendicular to the first surface (i.e., in the z-direction) and passing through the center point of the third main portion B412 itself. The third connecting portion 413 has a ninth cross section perpendicular to the line connecting the center point of the third main portion A411 and the center point of the third main portion B412 and is perpendicular to the first surface. Any the ninth cross section of the third connecting portion 413 in the direction from the third main portion A411 to the third main portion B412 is always completely coincident with the seventh section of the third main portion A411 and the eighth section of the third main portion B412.

A plurality of third columnar units 41 are distributed in a third periodic grid on the first surface of the substrate 10. The center points of the third main portions A411 of the third columnar units 41 constitute the grid points of the third periodic grid.

It can be understood that, in one embodiment, the center points of the third main portions A411 of the four adjacent third columnar units 41 in two adjacent rows and two adjacent columns constitute the four vertices A", B", C", and D" of the cell A"B"C"D". The third periodic grid may include a quadrilateral grid comprising multiple cells A"B"C"D". Preferably, the third periodic grid includes a parallelogram grid with cells A"B"C"D", where the cells A"B"C"D" are parallelograms with side A"B" parallel to side C"D".

In one embodiment, the center points of the third main portions A411 of the three adjacent third columnar units 41 in two adjacent rows constitute the three vertices A", B", and C" of the cell A"B"C". The third periodic grid may thus include a triangular grid comprising multiple cells A"B"C". Preferably, the third periodic grid includes isosceles or equilateral triangular grid units comprising cells A"B"C", i.e., the cells A"B"C" are isosceles or equilateral triangular grid units.

On the first surface of the substrate 10, the first periodic grid formed by the first columnar unit array, the second periodic grid formed by the second columnar unit array, and the third periodic grid formed by the third columnar unit array are nested with each other.

In one embodiment, the parallelogram grid with multiple cells ABCD in the first periodic grid, the parallelogram grid with multiple cells A'B'C'D' in the second periodic grid, and the parallelogram grid with multiple cells A"B"C"D" in the third periodic grid have identical dimensions. The side AB in cell ABCD, the side A'B' in cell A'B'C'D', and the side A"B" in cell A"B"C"D" are arranged in parallel. The side AC of the cell ABCD, the side A'C' of the cell A'B'C'D', and the side A"C" of the cell A"B"C"D" are arranged in parallel. All grid points of the periodic grids, i.e., the first main portion A211 of first columnar unit 21 in the first periodic grid, the second main portion A311 of second columnar unit 31 in the second periodic grid, and the third main portion A411 of third columnar unit 41 in the third periodic grid are mutually non-overlapping in their arrangement. Furthermore, the first columnar unit 21, the second columnar unit 31, and the third columnar unit 41 are arranged in a mutually non-contacting configuration.

In one embodiment, the isosceles or equilateral triangular grid with multiple cells ABC in the first periodic grid, the isosceles or equilateral triangular grid with multiple cells A'B'C' in the second periodic grid and the isosceles or equilateral triangular grid with multiple cells A"B"C" in the third periodic grid have identical dimensions. The side AB of cell ABC, the side A'B' of cell A'B'C' and the side A"B" of cell A"B"C" are arranged in parallel. All grid points of the periodic grid, i.e., the first main portion A211 of the first columnar unit 21 in the first periodic grid, the second main portion A311 of the second columnar unit 31 in the second periodic grid, and the third main portion A411 of the third columnar unit 41 in the third periodic grid are mutually non-overlapping in their arrangement. The first columnar unit 21, the second columnar unit 31, and the third columnar unit 41 are arranged in a mutually non-contacting configuration.

In one embodiment, the straight-line connecting the center point of the first main portion A211 and the center point of the first main portion B212 in the first columnar unit 21 is parallel to the straight-line connecting the center point of the second main portion A311 and the center point of the second main portion B312 in the second columnar unit 31 and the straight-line connecting the center point of the third main portion A411 and the center point of the third main portion B412 in the third columnar unit 41.as shown in FIG. 12 and FIG. 16.

In another embodiment, the straight-line connecting the center point of the first main portion A211 and the center point of the first main portion B212 in the first columnar unit 21 intersects the straight-line connecting the center point of the second main portion A311 and the center point of the second main portion B312 in the second columnar unit 31 and the straight-line connecting the center point of the third main portion A411 and the center point of the third main portion B412 in the third columnar unit 41, as shown in FIG. 8.

Preferably, the size of the third columnar unit 41 is exactly the same as that of the first columnar unit 21, and the third columnar unit 41 can be regarded as formed by translating the first columnar unit 21 or the second columnar unit 31 as a whole. Alternatively, the third columnar unit 41 can be regarded as formed by moving the first columnar unit 21 and rotating it by an angle α₂ around the center point of its first main portion A211. The direction of rotation can be clockwise or counterclockwise. The range of the angle α₂ can be 0°-180°. The lateral distance between the center point of the third main portion A411 of the third columnar unit 41 and the center point of the first main portion A211 of the first columnar unit 21 is x₂, and the longitudinal distance is y₂.

Referring to FIGS. 9 and 10, in the silicon capacitor electrode structure of the fourth embodiment shown in FIGS. 9 and 10, the first periodic grid formed by the first columnar unit array is distributed in a parallelogram grid, and each side AB of each cell ABCD is parallel to the x-direction, and each side AC forms an angle α₅ with the y-direction. Preferably, the angle α₅ ranges from 0° to 90°. The second periodic grid formed by the second columnar unit array is also distributed in a parallelogram grid, and each side A'B' of each cell A'B'C'D' is parallel to the x-direction, and each side A'C' forms an angle α₅ with the y-direction. Preferably, the angle α₅ ranges from 0° to 90°. The length of side AB is equal to the length of side A'B', and the length of side AC is equal to the length of side A'C'. The third periodic grid formed by the third columnar unit array is also distributed in a parallelogram grid, and the side A"B" of each cell A"B"C"D" is parallel to the x-direction, and the side A"C" forms an angle of α₅ with the y-direction. Preferably, the angle α₅ ranges from 0° to 90°.In this case, the length of side AB is equal to the length of side A'B', and the length of side AC is equal to the length of side A'C'.

It can be understood that the second columnar unit array can be formed by translating the first columnar unit array as a whole along the x-direction by a length x₁, then translating it along the y-direction by a length y₁, and finally rotating each first columnar unit 21 counterclockwise by an angle α₁ about the center point of the first main portion A211. The angle α₁ is 0°-180°. The third columnar unit array can be formed by translating the first columnar unit array as a whole along the x-direction by a length x₂, then translating it along the y-direction by a length y₂, and finally rotating each first columnar unit 21 clockwise by an angle α₂ about the center point of the first main portion A211. The angle α₂ is 0°-180°.

Referring to FIGS. 9 and 11, in the silicon capacitor electrode structure of the fourth embodiment shown in FIG. 9, the first periodic grid formed by the first columnar unit array can also be distributed in an isosceles triangular grid, and each side AB of each cell ABC forms an angle α₆ with the x-direction. Preferably, the angle α₆ ranges from 0° to 90°. Each side AC forms an angle α₇ with the y-direction, and preferably, the angle α₇ ranges from 0° to 90°. The second periodic grid formed by the second columnar unit array also has an isosceles triangular grid distribution, and each side A'B' of each cell A'B'C' forms an angle α₆ with the x-direction, and preferably, the angle α₆ ranges from 0° to 90°. Each side A'C' forms an angle of α₇ with the y-direction, preferably with the angle α₇ ranging from 0° to 90°. The length of side AB is equal to the length of side A'B', and the length of side AC is equal to the length of side A'C'. The third periodic grid formed by the third columnar unit array is also distributed in an isosceles triangular grid, and each side A"B" of each cell A"B"C" forms an angle α₆ with the x direction. Preferably, the angle α₆ ranges from 0° to 90°. Each side A"C" forms an angle of α₇ with the y-direction. Preferably, the angle α₇ ranges from 0° to 90°. The length of side AB is equal to the length of side A'B', and the length of side AC is equal to the length of side A'C'. The sum of the angles α₆ and α₇ is 90°.

It can be understood that the second columnar unit array can be formed by firstly translating the first columnar unit array as a whole along the x-direction by a length x₁, then translating it along the y-direction by a length y₁, and finally rotating each first columnar unit 21 counterclockwise by an angle α₁ about the center point of the first main portion A211. The angle α₁ is 0°-180°. The third columnar unit array can be formed by firstly translating the first columnar unit array as a whole along the x-direction by a length x₂, then translating it along the y-direction by a certain length y₂, and finally rotating each first columnar unit 21 clockwise by an angle α₁ about the center point of the first main portion A211. The angle α₁ is 0°-180°.

Referring to FIGS. 12 and 13, in the silicon capacitor electrode structure of the fifth embodiment shown in FIGS. 12 and 13, the first periodic grid formed by the first columnar unit array includes a quadrilateral grid having multiple cells ABCD. The second periodic grid formed by the second columnar unit array includes a quadrilateral grid having multiple cells A'B'C'D'. The third periodic grid formed by the third columnar unit array includes a quadrilateral grid with multiple cells A"B"C"D". The quadrilateral grid with multiple cells A"B"C"D" has the same size as the quadrilateral grid with multiple cells ABCD and as the quadrilateral grid with multiple cells A'B'C'D'.

In this embodiment, the grid points of the quadrilateral grid with multiple cells A"B"C"D" are located within the cells of the quadrilateral grid with multiple cells ABCD, and the grid points of the quadrilateral grid with cells A"B"C"D" are located on the diagonals of the cells of the quadrilateral grid with multiple cells ABCD. The grid points of the quadrilateral grid with multiple cells A"B"C"D" are located within the cells of the quadrilateral grid with multiple cells A'B'C'D', and the grid points of the quadrilateral grid with multiple cells A"B"C"D" are located on the diagonals of the cells of the quadrilateral grid with multiple cells A'B'C'D'.

Preferably, in a quadrilateral grid with multiple cells A'B'C'D', the grid point A' in cell A'B'C'D' is located on the n-equidistant lines of the diagonal AD of the quadrilateral grid with cells ABCD, and n is a constant. In a quadrilateral grid with cells A"B"C"D", the grid point A" in cell A"B"C"D" is located at the n-equidistant lines of the diagonal AD in cell ABCD of the quadrilateral grid with cells ABCD, and n is a constant. In a quadrilateral grid with cells A"B"C"D", the grid point A" in cell A"B"C"D" is located at the n-equidistant lines of the diagonal AD in cell ABCD of the quadrilateral grid with cells ABCD, where n is a constant, and in a quadrilateral grid with cells A"B"C"D". In a quadrilateral grid with cells A'B'C'D', the grid point A" in cell A"B"C"D" is located at the n-equidistant lines of the diagonal A'D' in cell A'B'C'D' of the quadrilateral grid with cells A'B'C'D', where n is a constant.

The sizes of the first columnar unit 21, the second columnar unit 31, and the third columnar unit 41 are exactly the same. The second columnar unit 31 can be regarded as formed by translating the first columnar unit 21 as a whole, with the translation direction corresponding to the straight-line direction of the diagonal of the first periodic grid formed by the first columnar unit array. The third columnar unit 41 may be formed by translating the first columnar unit 21 or the second columnar unit 31 as a whole, with the translation direction being the straight-line direction of the diagonal of the first periodic grid formed by the first columnar unit array, or the translation direction being the straight-line direction of the diagonal of the second periodic grid formed by the second columnar unit array.

In order to match the ratio of the length R_{I1} of the first main portion A211, the first main portion B212, and the first columnar unit 21, and to maximize the capacitance of the capacitor, in a preferred embodiment, in the parallelogram cell ABCD formed by the center point of the first main portion A211 in the first columnar unit 21, the longitudinal distance from side AB to side CD is Lₐ₁, and the length of side AB is L_{ab1}, where Lₐ₁ is not less than R_{I1}, and L_{ab1} is greater than R₁.

In order to match the ratio of the length R_{I2} of second main portion A311, the second main portion B312, and the second columnar unit 31, and to maximize the capacitance of the capacitor, in a preferred embodiment, in the parallelogram cell A'B'C'D' formed by the center points of the second main portion A311 of the second columnar unit 31,the longitudinal distance from side A'B' to side C'D' is L_{a'2}, and the length of side A'B' is L_{a'b'2}, where L_{a'2} is not less than R_{I2}, and L_{a'b'2} is greater than R₂.

In order to match the ratio of the length R_{I3} of the third main portion A411, the third main portion B412, and the third columnar unit 41, and to maximize the capacitance of the capacitor, in a preferred embodiment, in the parallelogram cell A"B"C"D" formed by the center point of the third main portion A411 in the third columnar unit 41, the longitudinal distance from the side A"B" to the side C"D" is L_{a"3}, and the length of the side A"B" is L_{a"b"3}, where L_{a"3} is not less than R_{I3}, and L_{a"b"3} is greater than R₃.

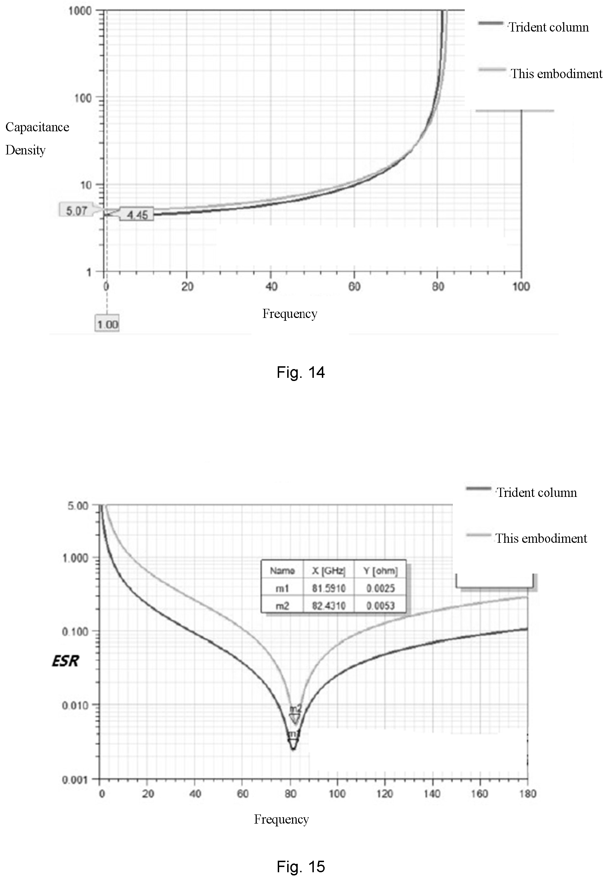

FIG. 14 is a capacitance density simulation diagram of the silicon capacitor electrode structure in the fifth embodiment of the present invention and the electrode structure of the traditional trident column model (as shown in FIG. 20). In the electrode structure of the trident column model shown in FIG. 20, the size of a single column in the columnar unit of the trident column is consistent with the size of the columnar unit in the present embodiment. In this embodiment, three groups of identical columnar unit arrays are nested, and the sizes of the columnar units are all: R_{I1}=5R_{A1}=5R_{B1}. It can be seen from FIG. 14 that C _{in this embodiment} = 5.07nF/mm²@1GHz, and C _{trident column} = 4.45nF/mm²@1GHz.

FIG. 15 is an equivalent series resistance (ESR) simulation diagram of the silicon capacitor electrode structure in the fifth embodiment of the present invention and the electrode structure of the traditional trident column model (as shown in FIG. 20). In the electrode structure of the trident column model shown in FIG. 20, the size of a single column in the base unit of the trident column is consistent with the size of the columnar unit in the present embodiment. In this embodiment, three groups of identical columnar unit arrays are nested, and the dimensions of the columnar units are all: R_{I1}=5R_{A1}=5R_{B1}. It can be seen from FIG. 15 that ESR _{in this embodiment} = 5.3mohm@SRF, and ESR _{trident column} = 2.5mohm@SRF.

Referring to FIGS. 16 and 17, in the silicon capacitor electrode structure of the sixth embodiment shown in FIGS. 16 and 17, the first periodic grid formed by the first columnar unit array includes a triangular grid having multiple cells ABC; the second periodic grid formed by the second columnar unit array includes a triangular grid having multiple cells A'B'C'. The third periodic grid formed by the third columnar unit array includes a triangular grid with multiple cells A"B"C". The triangular grid with multiple cells A"B"C" has the same size as the triangular grid with multiple cells ABC and the triangular grid with multiple cells A'B'C'.

In this embodiment, the grid points of the triangular grid having multiple cells A"B"C" are located on the grid lines of the triangular grid having multiple cells ABC. The grid points of the triangular grid having multiple cells A"B"C" are located on the grid lines of the triangular grid having multiple cells A'B'C'.

Preferably, the grid point A' in the cell A'B'C' of the triangular grid with multiple cells A'B'C' is located at the n-equidistant lines of the grid lines in the cell ABC of the triangular grid with multiple cells ABC, where n is a constant. In a triangular grid with multiple cells A'B'C', the grid point A' in cell A'B'C' is located at the n-equidistant lines of the grid lines in cell ABC of the triangular grid with multiple cells ABC, where n is a constant. And the grid point A" in the cell A"B"C" of the triangular grid with multiple cells A"B"C" is located at the n-equidistant lines of the grid line in the cell A'B'C' of the triangular grid with multiple cells A'B'C', where n is a constant.

The sizes of the first columnar unit 21, the second columnar unit 31, and the third columnar unit 41 are exactly the same. The second columnar unit 31 can be regarded as formed by translating the first columnar unit 21 as a whole, and the translation direction is the straight-line direction of the grid lines of the first periodic grid formed by the first columnar unit array. The third columnar unit 41 can be regarded as formed by translating the first columnar unit 21 or the second columnar unit 31 as a whole, with the translation direction being the straight-line direction of the grid lines of the first periodic grid formed by the first columnar unit array, or the translation direction being the straight-line direction of the grid lines of the second periodic grid formed by the second columnar unit array.

In order to match the ratio of the lengths R_{I1} of the first main portion A211, the first main portion B212, and the first columnar unit 21, and to maximize the capacitance of the capacitor, in a preferred embodiment, in the triangular grid ABC formed by the center point of the first main portion A211 in the first columnar unit 21, the longitudinal distance from the grid point A to the side BC is Lₐ₁, the length of side BC is L_{bc1}, Lₐ₁ is greater than R_{I1}, and L_{bc1} is greater than R₁.

In order to match the ratio of the lengths R_{I2} of the second main portion A311, the second main portion B312, and the second columnar unit 31, and to maximize the capacitance of the capacitor, in a preferred embodiment, in the triangular cell A'B'C' formed by the center points of the second main portion A311 in the second columnar unit 31,the longitudinal distance from grid point A' to side B'C' is set to L_{a'2}, the length of side B'C' is set to L_{b'c'2}, L_{a'2} is greater than R_{I2}, and L_{b'c'2} is greater than R₂.

In order to match the ratio of the lengths R_{I3} of the third main portion A411, the third main portion B412, and the third columnar unit 41, and to maximize the capacitance of the capacitor, in a preferred embodiment, in the triangular cell A"B"C" formed by the center point of the third main portion A411 in the third columnar unit 41, the longitudinal distance from the grid point A" to the side B"C" is set to L_{a"3}, the length of the side B"C" is set to L_{b"c"3}, L_{a"3} is greater than R_{I3}, and L_{b"c"3} is greater than R₃.

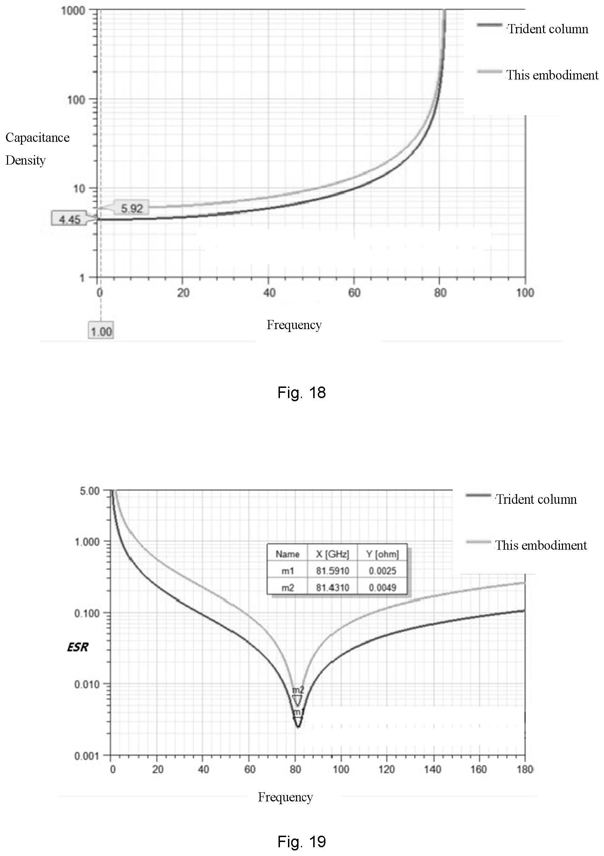

FIG. 18 is a capacitance density simulation diagram of the silicon capacitor electrode structure in the sixth embodiment of the present invention and the electrode structure of the traditional trident column model (as shown in FIG. 20). In the electrode structure of the trident column model shown in FIG. 20, the size of a single column in the columnar unit of the trident column is consistent with the size of the columnar unit in the present embodiment. In this embodiment, three groups of identical columnar unit arrays are nested, and the sizes of the columnar units are all: R_{I1}=5R_{A1}=5R_{B1}. It can be seen from FIG. 18 that C _{in this embodiment} = 5.92nF/mm²@1GHz, and C _{trident column} = 4.45nF/mm²@1GHz.

FIG. 19 is an equivalent series resistance (ESR) simulation diagram of the silicon capacitor electrode structure in the sixth embodiment of the present invention and the electrode structure of the traditional trident column model (as shown in FIG. 20). In the electrode structure of the trident column model shown in FIG. 20, the size of a single column in the columnar unit of the trident column is consistent with the size of the columnar unit in the present embodiment. In this embodiment, three groups of identical columnar unit arrays are nested, and the sizes of the columnar units are all: R_{I1}=5R_{A1}=5R_{B1}. It can be seen from FIG. 19 that ESR _{in this embodiment} = 4.9mohm@SRF, and ESR _{trident column} = 2.5mohm@SRF.

Referring to FIG. 21, FIG. 21 shows the capacitance density simulation diagram of the silicon capacitor electrode structure in the second, fifth, and sixth embodiments of the present invention and the electrode structure of the traditional trident column model shown in FIG. 20. It can be seen from the figure that C _{second embodiment} = 4.66 nF/mm²@1GHz, **C** _{fifth} embodiment = 5.07 nF/mm²@1GHz, C _{sixth embodiment} = 5.92 nF/mm²@1GHz, and C _{trident column} = 4.45 nF/mm²@1GHz.

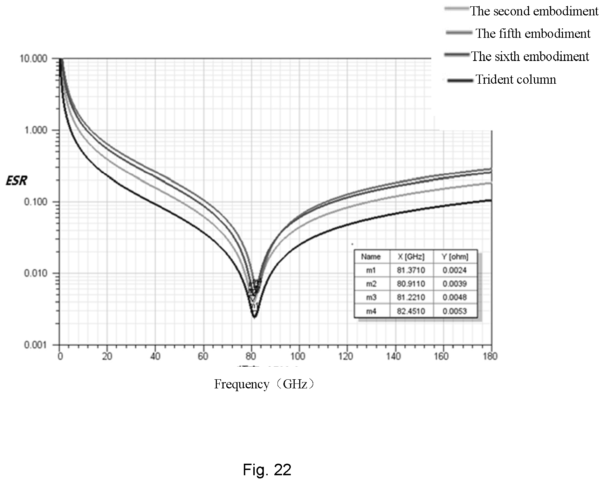

FIG. 22 shows the normalized ESR simulation diagram of the silicon capacitor electrode structure in the second, fifth, and sixth embodiments of the present invention and the electrode structure of the traditional model shown in FIG. 20. It can be seen from the figure that ESR _{second embodiment} = 3.9 mΩ@SRF, ESR _{fifth embodiment} = 5.3 mΩ@SRF, ESR _{sixth embodiment} = 4.8 mΩ@SRF, and ESR _{trident column} = 2.4 mΩ@SRF.

It can be concluded that the silicon capacitor formed by the silicon capacitor electrode structure in this invention has a higher capacitance per unit area and a lower equivalent series resistance than the silicon capacitor formed by the electrode structure of the traditional trident column model.

In addition, it can be seen from the implementation data that the silicon capacitors made by combining three columnar unit arrays have higher unit area capacitance and lower equivalent series resistance than those made by combining two columnar unit arrays.

It is understood that a silicon capacitor structure can be obtained by forming subsequent layer structures (using conventional methods) on the first surface of the substrate of the silicon capacitor electrode structure described above and on the outer surface of the columnar unit. Since the formation of subsequent layer structures is not the focus of this application, it will not be described in detail here.

In the above-mentioned multiple embodiments, the method of nesting and combining multiple groups of columnar unit arrays with different periodic grid distributions has higher capacitance values, lower equivalent series resistance, and longer service life, whether analyzed from the random path identical dielectric (resistance) model or the random conductive path percolation model.

Compared with the prior art, the silicon capacitor electrode structure according to the embodiment of the present invention can increase the surface area of the electrode in a limited space and improve the capacitance of the capacitor so that it can store more charge by using a nested combination of multiple sets of columnar units distributed in different periodic grids.

According to the silicon capacitor electrode structure of the invention, the special shapes of the first, second, and third columnar units reduce the accumulation of electrons on the outer peripheral surface, and in combination with the arrangement of different periodic grids, further reduce the equivalent series resistance (ESR) of the silicon capacitor electrode structure.

According to the silicon capacitor electrode structure of the present invention, the surface area is increased by arranging periodic grids in different arrays. This allows the volume of the capacitor to be reduced while maintaining the capacitance unchanged, which is very important for integration into small electronic devices, enabling higher capacitance to be achieved in a limited space.

The silicon capacitor electrode structure according to the present invention can improve the energy density. Since the energy density of a capacitor is related to its capacitance and operating voltage, more energy can be stored in the same volume by increasing the capacitance. The silicon capacitor electrode structure of the present invention increases the surface area of the electrodes in the same space by combining and nesting different arrays, thereby improving the capacitance of the capacitor.

The silicon capacitor electrode structure according to the embodiment of the present invention can further improve performance and stability. The columnar unit array arranged in a periodic grid can provide a uniform electric field distribution, which helps to improve the performance and stability of the capacitor. The uniform electric field distribution helps to reduce the leakage current of the capacitor, improve the insulation performance, and reduce losses. The columnar unit array arranged in a periodic grid can be achieved through a precise manufacturing process, improving the consistency of the manufacturing process. This helps to reduce performance variations among capacitors and enhance manufacturing controllability.

The silicon capacitor electrode structure according to the invention improves mechanical stability and enhances heat dissipation performance. The periodic grid arrangement of the columnar units provides better mechanical stability. This is particularly important for capacitors used in environments subject to vibration or mechanical stress. The periodic grid arrangement of the columnar units also improves the heat dissipation performance of the capacitor, as the gaps between the units facilitate air flow and reduce the operating temperature of the capacitor.

According to the silicon capacitor electrode structure of the invention, through the random path identical dielectric (resistance) model, multiple groups of columnar unit arrays are nested and arranged, making it easier to obtain information regarding the distribution of conductive paths and charge transfer behavior in the silicon capacitor electrode structure.

According to the silicon capacitor electrode structure of the invention, through a random conductive path penetration model, the nested arrangement of multiple sets of columnar unit arrays is simulated and analyzed for the random parallel connection of the equivalent resistances of the 3D capacitor structure, which allows for better design of the 3D morphology and prediction of the capacitor ESR.

The foregoing description of specific exemplary embodiments of the present invention is provided for illustrative and exemplary purposes. These descriptions are not intended to limit the invention to the precise form disclosed, and it will be apparent to those skilled in the art that numerous modifications and changes may be made in accordance with the teachings herein. The purpose of selecting and describing exemplary embodiments is to explain the specific principles of the invention and their practical application, thereby enabling those skilled in the art to practice and utilize different exemplary embodiments of the invention and various selections and modifications. The scope of the present invention is intended to be defined by the claims and their equivalents.

## Claims

1. A silicon capacitor electrode structure, comprising:
a substrate having a first surface;
a first columnar unit array formed on the first surface of the substrate and comprising a plurality of first columnar units distributed in a first periodic grid, each first columnar unit including a first main portion A and a first main portion B located at both ends thereof, and a first connecting portion connecting the first main portion A and the first main portion B, wherein a center point of the first main portion A of each first columnar unit constituting a grid point of the first periodic grid; and
a second columnar unit array formed on the first surface of the substrate and comprising a plurality of second columnar units distributed in a second periodic grid, each second columnar unit including a second main portion A and a second main portion B located at both ends thereof, and a second connecting portion connecting the second main portion A and the second main portion B, wherein a center point of the second main portion A in each second columnar unit constituting a grid point of the second periodic grid;
wherein any grid point of the first periodic grid does not coincide with any grid point of the second periodic grid, and the first columnar unit is not in contact with the second columnar unit.

2. The silicon capacitor electrode structure as claimed in claim 1, wherein a straight-line connecting the center point of the first main portion A and the center point of the first main portion B of the first columnar unit on the first surface is parallel to or intersects with a straight-line connecting the center point of the second main portion A and the center point of the second main portion B of the second columnar unit.

3. The silicon capacitor electrode structure as claimed in claim 1, wherein a size of the second columnar unit is the same as that of the first columnar unit, and the second columnar unit is formed by moving the first columnar unit and rotating it by an angle α₁ about the center point of the first main portion A thereof.

4. The silicon capacitor electrode structure as claimed in claim 3, wherein a range of the α₁ angle is 0°-180°.

5. The silicon capacitor electrode structure as claimed in claim 4, wherein the α₁ angle is 90°.

6. The silicon capacitor electrode structure as claimed in claim 1, wherein the first periodic grid comprises a parallelogram grid having multiple cells ABCD; the second periodic grid comprises a parallelogram grid having multiple cells A'B'C'D'; wherein the parallelogram grid with cells ABCD has same size as that of the parallelogram grid with cells A'B'C'D'.

7. The silicon capacitor electrode structure as claimed in claim 6, wherein a side AB is parallel to a side A'B', and a side AC is parallel to a side A'C'.

8. The silicon capacitor electrode structure as claimed in claim 1, wherein the center point of each second main portion A in each second columnar unit is located at a center point of a cell of the first periodic grid which is formed by using the center point of the first main portion A in the first columnar unit as a grid point.

9. The silicon capacitor electrode structure as claimed in claim 1, wherein the first columnar unit comprises a columnar portion protruding from the first surface and/or a hole recessed into the first surface.

10. The silicon capacitor electrode structure as claimed in claim 1, wherein the second columnar unit comprises a columnar portion protruding from the first surface and/or a hole recessed into the first surface.

11. The silicon capacitor electrode structure as claimed in claim 1, wherein the first main portion A is configured as a cylinder or circular hole with a diameter of RA1, the first main portion B is configured as a cylinder or circular hole with a diameter of RB1, and the first connecting portion has a length R1 perpendicular to a line connecting the center point of the first main portion A and the center point of the first main portion B, wherein RA1 = RB1 = R1;
the second main portion A is configured as a cylinder or circular hole with a diameter of RA2, the second main portion B is configured as a cylinder or circular hole with a diameter of RB2, and the second connecting portion has a length R2 perpendicular to a line connecting the center point of the second main portion A and the center point of the second main portion B, wherein RA2 = RB2 = R2.

12. The silicon capacitor electrode structure as claimed in claim 1, wherein the first periodic grid comprises a quadrilateral grid having multiple cells ABCD; the second periodic grid comprises a quadrilateral grid having multiple cells A'B'C'D';
the quadrilateral grid with cells ABCD has the same size as that of the quadrilateral grid with cells A'B'C'D', a grid points of the quadrilateral grid with cells A'B'C'D' are located within the cells of the quadrilateral grid with cells ABCD, and a grid points of the quadrilateral grid with cells A'B'C'D' are located on diagonals of the cells of the first quadrilateral grid with cells ABCD.

13. The silicon capacitor electrode structure as claimed in claim 12, wherein the grid points of the quadrilateral grid with cells A'B'C'D' are located on an n-equidistant lines of the diagonals of the cells of the first quadrilateral grid with cells ABCD, and n is a constant.

14. The silicon capacitor electrode structure as claimed in claim 1, wherein the first periodic grid includes a triangular grid having multiple cells ABC; the second periodic grid includes a triangular grid having multiple cells A'B'C';
the triangular grid with cells ABC is the same size as the triangular grid with cells A'B'C', and a grid points of the triangular grid with cells A'B'C' are located on grid lines of the triangular grid with cells ABC.

15. The silicon capacitor electrode structure as claimed in claim 14, wherein a grid points of the triangular grid with cells A'B'C' are located at an n-equidistant lines of the grid lines of the cells of the triangular grid with cells ABC, and n is a constant.

16. The silicon capacitor electrode structure as claimed in claim 1, further comprising a third columnar unit array, which is formed on the first surface of the substrate and comprises a plurality of third columnar units arranged in a third periodic grid pattern, each third columnar unit including a third main portion A and a third main portion B located at both ends thereof, and a third connecting portion connecting the third main portion A and the third main portion B, a center point of the third main portion A in the third columnar unit constituting a grid point of the third periodic grid;
wherein any grid point of the third periodic grid does not overlap with any grid point of the second periodic grid or the first periodic grid, and the third columnar unit does not come into contact with the first columnar unit or the second columnar unit.

17. The silicon capacitor electrode structure as claimed in claim 16, wherein a straight-line passing through a center points of the third main portion A and the third main portion B of the third columnar unit is parallel to or intersects a straight-line passing through the center of the first main portion A and the first main portion B of the first columnar unit or a straight-line passing through the center points of the second main portion A and the second main portion B of the second columnar unit.

18. The silicon capacitor electrode structure as claimed in claim 16, wherein a size of the third columnar unit is the same as that of the first columnar unit, and the third columnar unit is formed by moving the first columnar unit and rotating it by an angle α₂ about the center point of the first main portion A thereof, and a range of the α₂ angle is 0°-180°.

19. The silicon capacitor electrode structure as claimed in claim 16, wherein the first periodic grid comprises a parallelogram grid having cells ABCD; the second periodic grid comprises a parallelogram grid having cells A'B'C'D'; the third periodic grid comprises a parallelogram grid having cells A"B"C"D"; the size of the parallelogram grid with cells ABCD, the parallelogram grid with cells A'B'C'D', and the parallelogram grid with cells A"B"C"D" are all the same.

20. The silicon capacitor electrode structure as claimed in claim 16, wherein the first periodic grid comprises an isosceles triangular grid having cells ABC; the second periodic grid comprises an isosceles triangular grid having cells A'B'C'; the third periodic grid comprises an isosceles triangular grid having cells A"B"C"; the isosceles triangular grid with cells ABC, the isosceles triangular grid with cells A'B'C', and the isosceles triangular grid with cells A"B"C" all have the same size.

21. The silicon capacitor electrode structure as claimed in claim 16, wherein the third columnar unit comprises a columnar portion protruding from the first surface and/or a hole recessed into the first surface.

22. The silicon capacitor electrode structure as claimed in claim 16, wherein the first periodic grid includes a quadrilateral grid having cells ABCD; the second periodic grid includes a quadrilateral grid having cells A'B'C'D'; the third periodic grid includes a quadrilateral grid having cells A"B"C"D";
the quadrilateral grid with cells A"B"C"D" has the same size as the quadrilateral grid with cells ABCD and the quadrilateral grid with cells A'B'C'D';
the grid points of the quadrilateral grid with cells A"B"C"D" are located within the cells of the quadrilateral grid with cells ABCD, and the grid points of the quadrilateral grid with cells A"B"C"D" are located on the diagonals of the cells of the quadrilateral grid with cells ABCD; the grid points of the quadrilateral grid with cells A"B"C"D" are located within the cells of the quadrilateral grid with cells A'B'C'D', and the grid points of the quadrilateral grid with cells A"B"C"D" are located on the diagonals of the cells of the quadrilateral grid with cells A'B'C'D'.

23. The silicon capacitor electrode structure as claimed in claim 22, wherein the grid points of the quadrilateral grid with cells A"B"C"D" are located on the n-equidistant lines of the diagonals of the cells of the quadrilateral grid with cells ABCD, and n is a constant;
the grid points of the quadrilateral grid with cells A"B"C"D" are located on the n-equidistant lines of the diagonals of the cells of the quadrilateral grid with cells A'B'C'D', and n is a constant

24. The silicon capacitor electrode structure as claimed in claim 16, wherein the first periodic grid comprises a triangular grid having cells ABC; the second periodic grid comprises a triangular grid having cells A'B'C'; the third periodic grid comprises a triangular grid having cells A"B"C";
the triangular grid with cells A"B"C" has the same size as the triangular grid with cells ABC and the triangular grid with cells A'B'C';
the grid points of the triangular grid with cells A"B"C" are located on the grid lines of the triangular grid with cells ABC;
the grid points of the triangular grid with cells A"B"C" are located on the grid lines of the triangular grid with cells A'B'C'.

25. The silicon capacitor electrode structure as claimed in claim 24, wherein the grid points of the triangular grid with cells A"B"C" are located at the n-equidistant lines of the grid lines of the cells of the triangular grid with cells ABC, and n is a constant;
the grid points of the triangular grid with cells A"B"C" are located at the n-equidistant lines of the grid lines of the cells of the triangular grid with cells A'B'C', and n is a constant.

26. The silicon capacitor electrode structure as claimed in claim 16, wherein the third main portion A is configured as a cylinder or circular hole with a diameter of RA3, the third main portion B is configured as a cylinder or circular hole with a diameter of RB3, and the first connecting portion has a length R3 perpendicular to the center line connecting the third main portion A and the third main portion B, wherein RA3 = RB3 = R3;
the line connecting the center point of the third main portion A and the center point of the third main portion B in the third columnar unit has a length L₃, and the length L₃ is greater than or equal to a half circumference of the third main portion A or the third main portion B.

27. A silicon capacitor, comprising a silicon capacitor electrode structure as claimed in any one of claims 1 to 26.
